# EUROPÄISCHE PATENTSCHRIFT

(11) **EP 2 347 501 B1**
(45) Veröffentlichungstag und Bekanntmachung des Hinweises auf die Patenterteilung: **30.01.2013**
(21) Anmeldenummer: 09782837.0
(22) Anmeldetag: 10.09.2009
(51) Int. Cl.: H02P 1/40, G05F 1/10, H02H 7/12, H03K 17/0814, H03K 17/10, H02M 1/34, G05F 1/12

(54) **DREHSTROMSTELLER**
THREE-PHASE AC POWER CONTROLLER
VARIATEUR TRIPHASÉ

(30) Priorität: 10.11.2008 AT 17452008
(43) Veröffentlichungstag der Anmeldung: 27.07.2011
(73) Patentinhaber: Siemens Aktiengesellschaft, 80333 München (DE)
(72) Erfinder: NICOLTSIOS, Grammenos, A-1190 Wien (AT); PICHORNER, Heinz, A-3464 Pettendorf (AT)
(86) Internationale Anmeldenummer: PCT/EP2009/061716
(87) Internationale Veröffentlichungsnummer: WO 2010/052048

(56) Entgegenhaltungen:
- EP-A- 0 488 201
- DE-A1- 10 003 692
- JP-A- 7 059 255

## Beschreibung

Die Erfindung betrifft einen Drehstromsteller, drei Stränge mit jeweils einem Eingang und einem Ausgang umfassend, mit fünf Paaren antiparallel geschalteter Ventile zur Drehfeldumkehrung, wobei der erste Eingang über ein erstes Paar mit dem ersten Ausgang verbunden ist, der zweite Eingang über ein zweites Paar mit dem zweiten Ausgang und über ein drittes Paar mit dem dritten Ausgang verbunden ist und der dritte Eingang über ein viertes Paar mit dem zweiten Ausgang und über ein fünftes Paar mit dem dritten Ausgang verbunden ist.

Drehstromsteller gehören zu den netzgeführter. Stromrichtern. Bei konstanter Frequenz wird die Spannung variabel verstellt. Zu diesem Zweck sind in jedem Strang ein Paar antiparallel geschalteter Ventile, insbesondere Thyristoren, angeordnet.

Drehstromsteller mit Drehfeldumkehrung umfassen in der Regel fünf Paare antiparallel geschalteter Ventile, wie in Figur 1 dargestellt. Ein solcher Drehstromsteller ist auch aus der DE 100 03 692 A1 bekannt. Dabei ist in einem Strang ein Paar angeordnet und in den übrigen zwei Strängen ist jeweils ein Eingang über jeweils ein Paar mit jedem Ausgang dieser beiden übrigen Stränge verbunden. Das erste Paar in dem einen Strang wird immer angesteuert, in den beiden übrigen Strängen erfolgt die Ansteuerung der Ventilpaare entsprechend der gewünschten Drehrichtung des Drehfeldes. Entweder der zweite Eingang wird über das zweite Paar an den zweiten Ausgang und der dritte Eingang über das fünfte Paar an den dritten Ausgang geschaltet oder der zweite Eingang wird über das dritte Paar an den dritten Ausgang und der dritte Eingang über das vierte Paar an den zweiten Ausgang geschaltet.

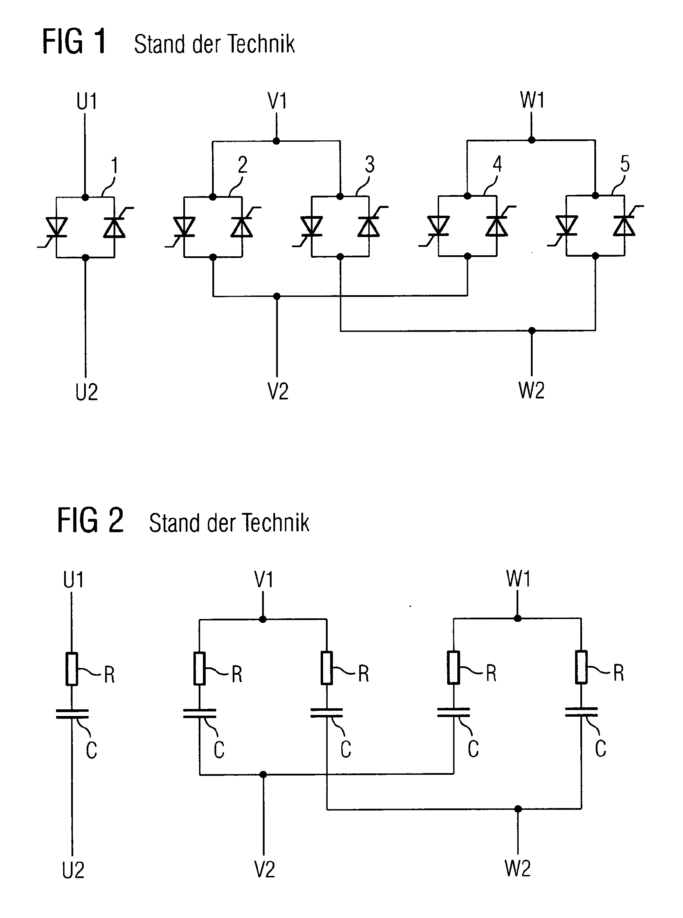

Zur Entlastung der einzelnen Stränge ist nach dem Stand der Technik, wie in Figur 2 dargestellt, parallel zu jedem Ventilpaar eine FC-Zweig, bestehend aus einem Widerstand und einem in Reihe geschalteten Kondensator, angeordnet. Dabei sind immer nur drei Zweige gleichzeitig belastet. Für eine Snubberbeschaltung (ein anderer gebräuchlicher Ausdruck ist "Entlastungsbeschaltung" oder TSE-Beschaltung) eines Drehstromstellers mit Drehfeldumkehrung sind somit fünf Widerstände und fünf Kondensatoren erforderlich, wobei für eine ausreichende Abfuhr der in den Widerständen entstehenden Wärme zu sorgen ist. Dies führt insbesondere bei Drehstromstellern mit einer Leistung größer 40 Kilowatt zu einem entsprechenden Platzbedarf innerhalb eines Geräteaufbaus. Das Prinzip von Entlastungsschaltungen für Ventilpaare ist beispielsweise auch aus der EP0 488 201 A1 oder der JP 7059255 bekannt.

Der Erfindung liegt die Aufgabe zugrunde, für einen Drehstromsteller der eingangs genannten Art eine Verbesserung gegenüber dem Stand der Technik anzugeben.

Erfindungsgemäß wird diese Aufgabe gelöst durch die Merkmale des Anspruchs 1. Dabei ist als Snubberbeschaltung an jeden Eingang und an jeden Ausgang jeweils ein 3RC-Halbzweig in der Weise geschaltet, dass ein Ende des jeweiligen RC-Halbzweigs mit dem jeweiligen Eingang bzw. Ausgang verbunden ist und dass die zweiten Enden dieser RC-Ralbzweige mittels einer Querverbindung miteinander verbunden sind. Bei einer solchen Entlastungsbeschaltung werden alle Widerstände belastet, unabhängig davon, welches Ventilpaar gerade angesteuert wird. Der Platzbedarf für alle Widerstände sinkt damit gegenüber dem Platzbedarf nach dem Stand der Technik um ca. 40%.

In einer vorteilhaften Ausprägung der Erfindung sind die beiden RC-Halbzweige eines Strangs aus jeweils einem Kondensator in Reihe mit jeweils einem Widerstand gebildet.

Dies ermöglicht einen einfachen symmetrischen Aufbau mit baugleichen Bauelementen.

Es kann aber auch von Vorteil sein, wenn die beiden RC-Halbzweige eines Strangs in der Weise gebildet sind, dass an den jeweiligen Eingang und den jeweiligen Ausgang ein Kondensator angeschaltet ist und dass zwischen die Kondensatoren ein Widerstand angeordnet ist, der eine Mittelanzapfung zur Anschaltung der Querverbindung aufweist. Eine derartige Ausprägung erlaubt mitunter eine weitere Platzersparnis.

Von Vorteil ist es insbesondere, wenn die Stränge zur Leitung eines Gerätestromes von wenigstens 100 Ampere ausgelegt sind. Solche Drehstromsteller mit wenigstens 40-50 Kilowatt benötigen entsprechend große Entlastungswiderstände, wodurch eine Platzersparnis besonders ins Gewicht fällt.

Die Erfindung wird nachfolgend in beispielhafter Weise unter Bezugnahme auf die beigefügten Figuren erläutert. Es zeigen in schematischer Darstellung:
- Fig. 1: Anordnung der Ventilpaare eines Drehstromstellers mit Drehfeldumkehrung
- Fig. 2: Snubberbeschaltung nach dem Stand der Technik
- Fig. 3: Vorteilhafte Snubberbeschaltung

Wie in Fig. 1 dargestellt ist der Drehstromsteller mit drei Eingängen U1, V1, W1 an die Phasen eines Drehstromnetzes anschließbar. Der erste Eingang U1 ist über ein erstes Paar 1 antiparallel geschalteter Ventile mit einem ersten Ausgang U2 des Drehstromstellers verbunden. Die Ventile dieses ersten Paars 1 werden unabhängig von der gewünschten Richtung des Drehfeldes immer angesteuert.

Der zweite Eingang V1 des Drehstromstellers ist über ein zweits Paar 2 antiparallel geschalteter Ventile mit einem zweiten Ausgang V2 und über ein drittes Paar 3 antiparallel geschalteter Ventile mit einem drittes Ausgang W2 des Drehstromstellers verbunden. Der dritte Eingang W3 ist in gleicher Weise über zwei weitere Paare 4, 5 antiparallel geschalteter Ventile mit dem zweiten und dem dritten Ausgang V2, W2 verbunden. Die Ventile sind üblicherweise als Thyristoren mit einer entsprechenden Phasenanschnittsteuerung ausgebildet.

Abhängig von der gewünschten Richtung des Drehfeldes werden im Betrieb entweder die Ventile des zweiten und des fünften Paars 2, 5 oder des dritten und des vierten Paars 3, 4 angesteuert.

In Fig. 2 ist eine Snubberbeschaltung für die in Fig. 1 dargestellten Ventilpaare 1, 2, 3, 4, 5 nach dem Stand der Technik dargestellt. Dabei sind fünf RC-Zweige mit jeweils einem Widerstand R und jeweils einem in Serie geschalteten Kondensator C angeordnet. Jedem Ventilpaar 1, 2, 3, 4, 5 ist ein RC-Zweig parallel geschaltet. Im Betrieb wird der erste RC-Zweig, welcher den ersten Eingang U1 mit dem ersten Ausgang U2 verbindet, immer belastet. Abhängig von der gewählten Richtung des Drehfeldes werden von den übrigen vier RC-Zweigen nur die zwei belastet, die den gezündeten Ventilpaaren 2, 5 bzw. 3, 4 parallel geschaltet sind.

Jeder RC-Zweig muss bei dieser gekannten Anordnung die volle Belastung eines Stranges aufnehmen. Die Widerstände R sind dementsprechend zu dimensionieren. Der damit verbundene Platzbedarf unter Berücksichtigung eines Kühlkonzepts bestimmt die Größe des Drehstromstellers entscheidend mit.

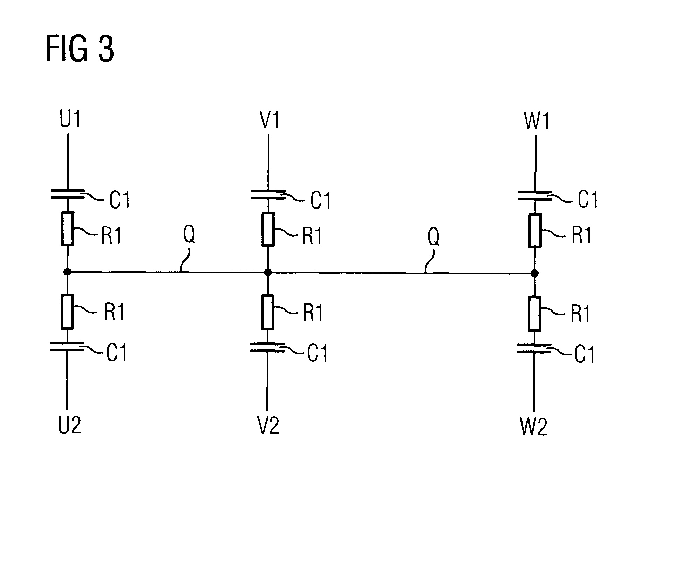

Die in Fig. 3 dargestellte Snubberbeschaltung ermöglicht eine Verringerung der Baugröße des Drehstromstellers durch die Reduzierung des Platzbedarfs für die Widerstände R1 um ca. 40%. Dabei sind drei RC-Zweige als sechs RC-Halbzweige ausgebildet, welche eine Querverbindung Q aufweisen. Im Betrieb wird unabhängig von der Richtung des Drehfeldes jeder dieser sechs Halbzweige belastet.

Gegenüber der in Fig. 2 dargestellten Standardlösung halbieren sich auf diese Weise die Widerstandswerte der einzelnen Widerstände R1 und die Kapazitäten der Kondensatoren C1 verdoppeln sich. Dadurch steigt jedoch nicht der Platzbedarf der Kondensatoren C1, weil die Kondensatorbaugröße in erster Linie von der Spannungsbelastung abhängt. Die Spannungsbelastung für beide Kondensatoren C1 eines Stranges bleibt gegenüber der Spannungsbelastung eines Kondensators C in Fig. 2 unverändert. Der Platzbedarf für die beiden Kondensatoren C1 eines Stranges entspricht somit ungefähr dem Platzbedarf eines Kondensators C in Fig. 2. Die Reduktion der Widerstandswerte, insbesondere die Querschnittsreduktion der Widerstände R1 gegenüber den Widerständen R in Fig. 2, kommt also voll zum Tragen.

Der Aufbau eines RC-Halbzweigs kann beliebig an ein Gerätelayout angepasst werden. Entweder jeder RC-Halbzweig ist als Serienschaltung von Widerständen R1 und Kondensatoren C1 ausgeführt, oder für jeden Strang ist nur ein Widerstand angeordnet, welcher eine Mittelanzapfung zur Anschaltung der Querverbindung Q aufweist. Selbstverständlich können auch innerhalb eines RC-Halbzweigs mehrere Widerstände in Serie oder mehrere Kondensatoren parallel geschaltet werden, um einer Belastung im Betrieb standzuhalten.

## Patentansprüche

1. Drehstromsteller, drei Stränge mit jeweils einem Eingang (U1, V1, W1) und einem Ausgang (U2, V2, W2) umfassend, mit fünf Paaren (1, 2, 3, 4, 5) antiparallel geschalteter Ventile zur Drehfeldumkehrung, wobei der erste Eingang (U1) über ein erstes Paar (1) mit dem ersten Ausgang (U2) verbunden ist, der zweite Eingang (V1) über ein zweites Paar (2) mit dem zweiten Ausgang (V2) und über ein drittes Paar (3) mit dem dritten Ausgang (W2) verbunden ist und der dritte Eingang (W1) über ein viertes Paar (4) mit dem zweiten Ausgang (V2) und über ein fünftes Paar (5) mit dem dritten Ausgang (W2) verbunden ist, **dadurch gekennzeichnet, dass** als Snubberbeschaltung an jeden Eingang (U1, V1, W1) und an jeden Ausgang (U2, V2, W2) jeweils ein RC-Halbzweig in der Weise geschaltet ist, dass ein Ende des jeweiligen RC-Halbzweigs mit dem jeweiligen Eingang (U1 V1, W1) bzw. Ausgang (U2, V2, W2) verbunden ist und dass die zweiten Enden dieser RC-Halbzweige mittels einer Querverbindung (Q) miteinander verbunden sind.

2. Drehstromsteller nach Anspruch 1, **dadurch gekennzeichnet, dass** die beiden RC-Halbzweige eines Strangs aus jeweils einem Kondensator (C1) in Reihe mit jeweils einem Widerstand (R1) gebildet sind.

3. Drehstromsteller nach Anspruch 1, **dadurch gekennzeichnet, dass** die beiden RC-Halbzweige eines Strangs in der Weise gebildet sind, dass an den jeweiligen Eingang (U1, V1, W1) und den jeweiligen Ausgang (U2, V2, W2) ein Kondensator (C1) angeschaltet ist und dass zwischen die Kondensatoren (C1) ein Widerstand angeordnet ist, der eine Mittelanzapfung zur Anschaltung der Querverbindung (Q) aufweist.

4. Drehstromsteller nach einem der Ansprüche 1 bis 3, **dadurch gekennzeichnet, dass** die Stränge zur Leitung eines Gerätestromes von wenigstens 100 Ampere ausgelegt sind.

## Claims

1. Three-phase AC power controller including three lines with an input (U1, V1, W1) and an output (U2, V2, W2) in each instance, having five pairs (1, 2, 3, 4, 5) of valves connected in an anti-parallel fashion to the rotating field reversal, wherein the first input (U1) is connected to the first output (U2) via a first pair (1), the second input (V1) is connected to the second output (V2) via a second pair (2) and to the third output (W2) via a third pair (3) and the third input (W1) is connected to the second output (V2) via a fourth pair (4) and to the third output (W2) via a fifth pair (5), **characterised in that** an RC half-branch is connected in each instance as a snubber circuit to each input (U1, V1, W1) and to each output (U2, V2, W2) in each instance such that one end of the respective RC half-branch is connected to the respective input (U1, V1, W1) and/or output (U2, V2, W2) and that the second ends of these RC half-branches are connected to one another by means of a transverse connection (Q).

2. Three-phase AC power controller according to claim 1, **characterised in that** the two RC half-branches of a line are formed in each instance from a capacitor (C1) in series with a resistor (R1) in each instance.

3. Three-phase AC power controller according to claim 1, **characterised in that** the two RC half-branches of a line are formed in such a way that a capacitor (C1) is conencted to the respective input (U1, V1, W1) and to the respective output (U2, V2, W2) and that a resistor is arranged between the capacitors (C1) which comprises a centre tapping for connection with the transverse connection (Q).

4. Three-phase AC power controller according to one of claims 1 to 3, **characterised in that** the lines are configured to conduct a device current of at least 100 amperes.

## Revendications

1. Commutateur triphasé comprenant trois phases ayant respectivement une entrée (U1, V1, W1) et une sortie (U2, V2, W2), comprenant cinq paires (1, 2, 3, 4, 5) de valves montées en opposition pour l'inversion du champ tournant, la première entrée (U1) étant reliée à la première sortie (U2) par une première paire (1), la deuxième entrée (V1) étant reliée à la deuxième sortie (V2) par une deuxième paire (2) et à la troisième sortie (W2) par une troisième paire (3) et la troisième entrée (W1) étant reliée à la deuxième sortie (V2) par une quatrième paire (4) et à la troisième sortie (W2) par une cinquième paire (5), **caractérisé en ce qu'**il est monté comme circuit d'amortissement à chaque entrée (U1, V1, W1) et à chaque sortie (U2, V2, W2) respectivement une demi-branche RC de manière à ce qu'une extrémité de la demi-branche RC respective soit reliée à l'entrée (U1, V1, W1) ou à la sortie (U2, V2, W2) respective et de manière à ce que les deuxièmes extrémités de ces demi-branches RC soient reliées entre elles au moyen d'une liaison (Q) transversale.

2. Commutateur triphasé suivant la revendication 1, **caractérisé en ce que** les deux demi-branches RC d'une phase sont formées respectivement d'un condensateur (C1) en série avec respectivement une résistance.

3. Commutateur triphasé suivant la revendication 1, **caractérisé en ce que** les deux demi-branches RC d'une phase sont formées de manière à ce qu'un condensateur (C1) soit monté à l'entrée (U1, V1, W1) respective et à la sortie (U2, V2, W2) respective et de manière à ce qu'une résistance, qui a une prise médiane pour le montage de la liaison (Q) transversale, soit montée entre les condensateurs (C1).

4. Commutateur triphasé suivant l'une des revendications 1 à 3, **caractérisé en ce que** les phases sont conçues pour conduire un courant d'appareil d'au moins 100 ampères.
